(19) Europäisches Patentamt
European Patent Office
Office européen des brevets

(11) Publication number: **0 488 245 A1**

(12) # EUROPEAN PATENT APPLICATION

(21) Application number: **91120313.1**

(51) Int. Cl.[5]: **G03F 1/14**

(22) Date of filing: **27.11.91**

(30) Priority: **29.11.90 JP 325615/90**

(43) Date of publication of application:
**03.06.92 Bulletin 92/23**

(84) Designated Contracting States:
**DE**

(71) Applicant: **ASAHI GLASS COMPANY LTD.**
**1-2, Marunouchi 2-chome**
**Chiyoda-ku Tokyo 100(JP)**
Applicant: **MITSUBISHI DENKI KABUSHIKI KAISHA**
**2-3, Marunouchi 2-chome Chiyoda-ku**
**Tokyo(JP)**

(72) Inventor: **Unoki, Masao**
**1319-1, Hon-cho, Tsurugamine, Asahi-ku**
**Yokohama-shi, Kanagawa-ken(JP)**
Inventor: **Yokotsuka, Shunsuke**
**2-59-1, Tsurugamine, Asahi-ku**
**Yokohama-shi, Kanagawa-ken(JP)**
Inventor: **Yoshioka, Nobuyuki, c/o Mitsubishi Denki K. K.**
**L.S.I. Kenkyusho, 1, Mizuhara 4-chome**
**Itami-shi, Osaka(JP)**
Inventor: **Watakabe, Yaichiro, c/o Mitsubishi Denki K. K.**
**L.S.I. Kenkyusho, 1, Mizuhara 4-chome**
**Itami-shi, Osaka(JP)**

(74) Representative: **Wächtershäuser, Günter, Dr.**
**Tal 29**
**W-8000 München 2(DE)**

(54) **Phase-shifting mask and process for its production.**

(57) A phase-shifting mask to be used for increasing the resolving power of photolithography, which has a shifter pattern to shift the phase of light, wherein the shifter pattern is made of a polymer having a fluorine-containing aliphatic cyclic structure.

EP 0 488 245 A1

The present invention relates to a phase-shifting mask to be used for improving the resolving power of photolithography employed for the production of LSI. Particularly, it relates to a phase-shifting mask wherein a polymer having a fluorine-containing aliphatic cyclic structure is used as the material for a shifter pattern to shift the phase, and to a process for its production.

Heretofore, photolithography has been well known wherein an enlarged pattern on a photo mask is repeatedly projected in a reduced size on a wafer to form a desired LSI pattern.

A conventional photomask has a structure having a light shielding pattern of e.g. Cr, Mo or Si formed on a quartz glass substrate, as shown in Figure 2. A phase-shifting exposure method has been proposed whereby the resolving power of lithography is improved by applying to a reduced optical photolithography a mask having a shifter pattern made of a light transmitting material to shift the phase of light, as shown in Figure 1 (M. D. Levenson et al, IEEE Transactions on Electron Devices, Vol. ED-29, No. 12, 1828 (1982)). At present, such an exposure method is being actively studied and developed. Such a mask is referred to as a phase-shifting mask.

The shifter pattern material for the phase-shifting mask is required to have good light transmittance and a refractive index close to glass to minimize the reflection of light at the interface with the glass substrate. Further, it is required to be excellent in fine processability. As such material, an inorganic film of e.g. $SiO_2$ or resist has been studied. As shown in Figure 3, the shifter pattern is usually formed on a light shielding pattern of e.g. Cr, Mo or Si, after the formation of such a light shielding pattern.

A film of a $SiO_2$ is formed on the light shielding pattern by a sputtering method or a chemical vapor deposition (CVD) method and then subjected to patterning by electron beam drawing and dry etching. $SiO_2$ is the same material as substrate glass, and its refractive index is substantially equal to glass, and it has a feature that it is excellent in fine processability and has high mechanical strength. However, film forming is conducted by a spattering method or a CVD method, whereby the thermal stress is substantial, and there will be a problem that a strain of the mask tends to be large, and the process tends to be large in scale. Further, the material is the same as the substrate, whereby there will be a problem that at the time of etching, it is difficult to take a selection ratio to the substrate.

On the other hand, the resist has a feature that it can be spin-coated, whereby an electron beam drawing pattern can be used as it is, whereby the process can be simplified. However, it has a problem that the refractive index is large, the resistance to light is low, and the absorption of light is substantial.

It is an object of the present invention to overcome the above mentioned drawbacks inherent to the shifter of a phase-shifting mask made of the conventional material and to provide a new phase-shifting mask in which a shifter material is used which has a low stress, high light transmittance, a refractive index equal to or lower than glass and resistance to light, and whereby a selection ratio to the substrate can be taken at the time of etching. Said shifter material can be formed into a film by spin-coating.

The present inventors have conducted extensive researches with recognition of the above-mentioned problems and as a result, have found that a polymer having a fluorine-containing aliphatic cyclic structure has high light transmittance and a refractive index substantially equal to a glass substrate, provides etching selectivity to the glass substrate or to a light shielding pattern and is excellent in fine processability and is very advantageous as a material for presenting a sufficiently strong sifter pattern.

Thus, the present invention has been accomplished on the basis of the above discovery and provides a phase-shifting mask to be used for increasing the resolving power of photolithography, which has a shifter pattern to shift the phase of light, wherein the shifter pattern is made of a polymer having a fluorine-containing aliphatic cyclic structure, and a process for producing a phase-shifting mask, which comprises a step of forming on a mask substrate a film of a polymer having a fluorine-containing aliphatic cyclic structure, a step of forming on the polymer film a high melting point inorganic film, a step of forming on the high melting point inorganic film a resist pattern by an electron beam exposure method, a step of etching the high melting point inorganic film while using the resist pattern as a mask, a step of etching the polymer film while using the high melting point inorganic pattern as a mask, and a step of removing the high melting point inorganic film on the polymer pattern by a mixed acid.

In the accompanying drawings:

Figure 1 is a cross sectional view illustrating a specific structure of a phase-shifting mask.

Figure 2 is a cross sectional view illustrating a structure of a conventional photomask.

Figure 3 is a cross sectional view illustrating a process for producing a phase-shifting mask as an example of the present invention.

Now, the present invention will be described in detail with reference to the preferred embodiments.

In the present invention, the polymer having a fluorine-containing aliphatic cyclic structure includes a wide range of such polymers including known or well known polymers. Thus, in the present invention, a fluorine-containing polymer having the above specified cyclic structure in its main chain is preferably

employed.

For example, those having the following cyclic structures may be mentioned:

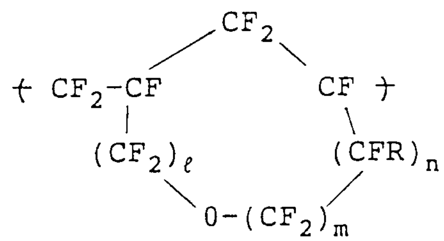

wherein $\ell$ is from 0 to 5, m is from 0 to 4, n is 0 or 1, provided that $\ell + m + n$ is from 1 to 6, and R is F or $CF_3$;

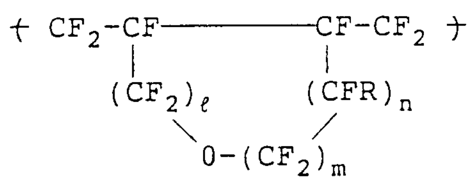

wherein $\ell$ is from 0 to 5, m is from 0 to 4, n is 0 or 1, provided that $\ell + m + n$ is from 1 to 6, and R is F or $CF_3$;

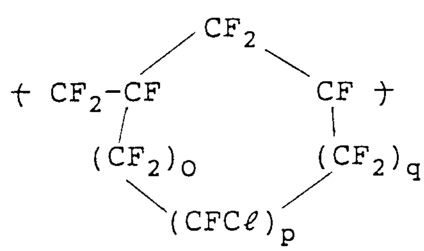

wherein each of o, p and q is from 0 to 5, provided $o + p + q$ is from 1 to 6; and

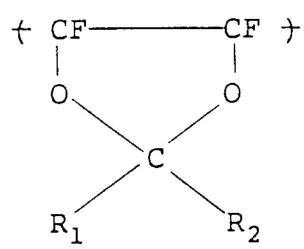

wherein $R_1$ is F or $CF_3$, and $R_2$ is F or $CF_3$. Among these, polymers having the following cyclic structures are representative. However, the present invention is by no means restricted to such specific examples.

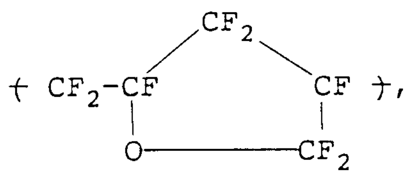

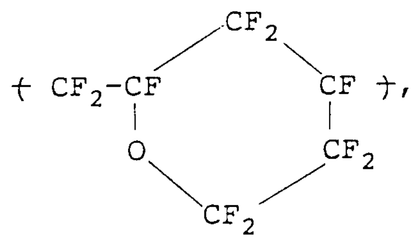

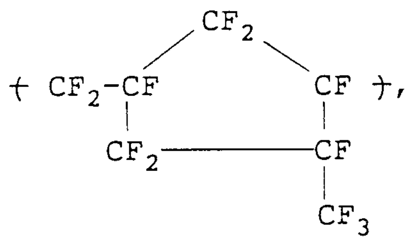

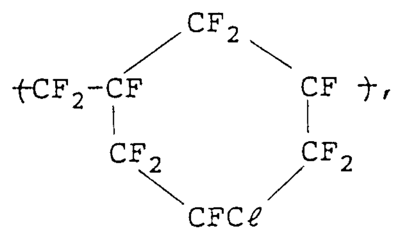

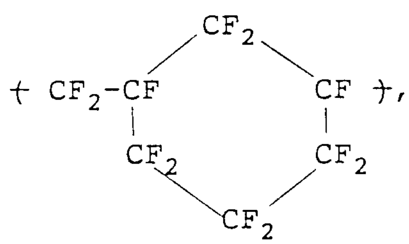

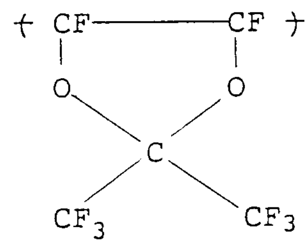

The following two processes may be mentioned for the preparation of these polymers. However, the processes for their preparation are not limited to such specific examples.

1. By cyclic polymerization:

(1) 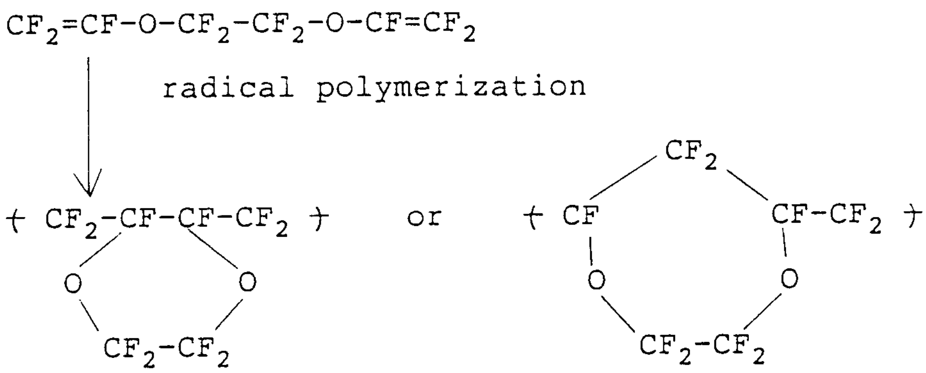


(e.g. USP 3,418,303 and GB 1,106,344)

(2) 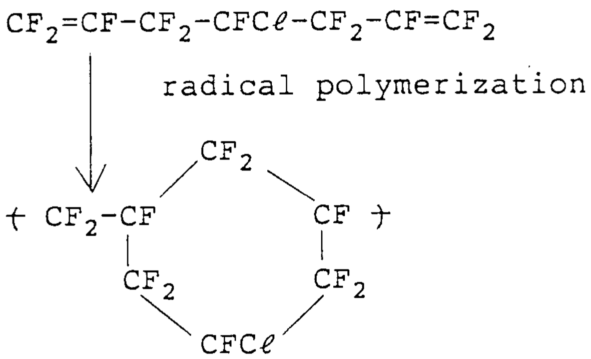


(e.g. USP 3,202,643)

(3) 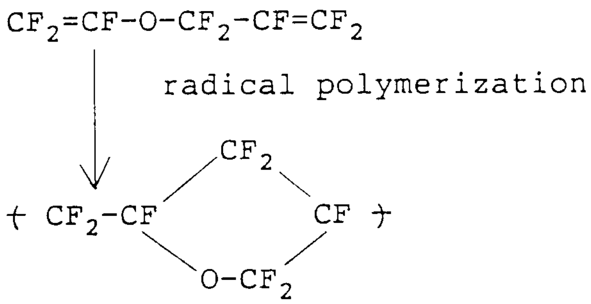


2. By means of a cyclic monomer such as perfluoro-2,2-dimethyl-1,3-dioxol (USP 3,978,030 and 4,754,009)

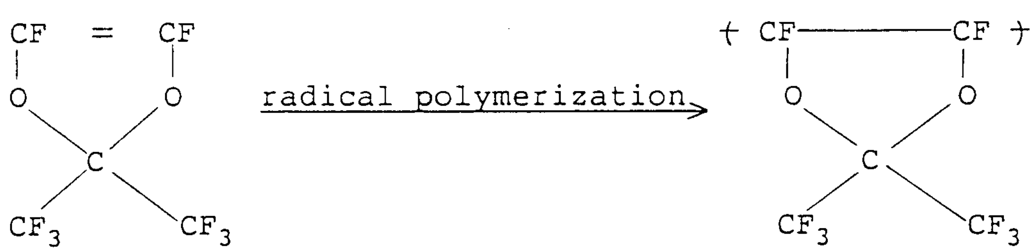


Exemplified above are polymers having a perfluoro aliphatic cyclic structure. However, in the present invention, those having a part of fluorine atoms of the above exemplified polymers substituted by other

hydrogen atoms or organic groups, or those having a cyclic structure such as

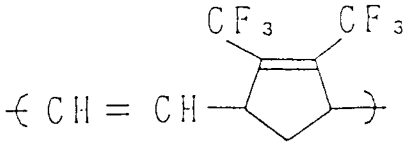

or

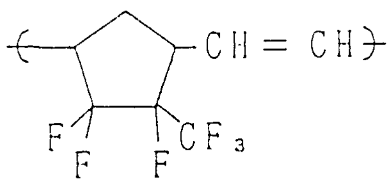

obtainable by metathesis polymerization, may also be employed.

Thus, the polymer having a specific cyclic structure of the present invention can readily and advantageously be obtained by the cyclic polymerization as described above. In particular, by using a monomer which has two polymerizable groups having different polymerizabilities in the molecule and wherein the straight chain portion of the linking chain connecting the two polymerizable groups has from 2 to 7 atoms, the cyclic polymerization can be proceeded smoothly and advantageously while suppressing a side reaction for gelation even without employing super high pressure conditions or highly diluted conditions.

As a monomer suitable for such cyclic polymerization, it is firstly desired that the monomer has two carbon-carbon multiple bonds which are different in the polymerizability. Usually, carbon-carbon double bonds are employed. Two multiple bonds differing in the types or in the structures, are employed. For example, there may be employed a fluorine-containing monomer having two multiple bonds having asymmetrical structures, a monomer having a vinyl group and an allyl group, a monomer having a vinyl ether group and a vinyl group, a monomer having a fluorine-containing multiple bond and a hydrocarbon multiple bond and a monomer having a perfluoro multiple bond and a partially fluorinated multiple bond. Secondly, the straight chain portion of the linking chain connecting such two carbon-carbon multiple bonds, has from 2 to 7 atoms. When the straight chain portion of the linking chain has 0 or one atom, the cyclic polymerization will hardly take place. The same is true also in a case where the straight chain portion has 8 or more atoms. Usually, this number of atoms is preferably from 2 to 5. The linking chain is not limited to a straight chain and may have a side chain structure or a cyclic structure. Further, the constituting atoms are not limited to carbon atoms and may contain hetero atoms such as O, S, N. Thirdly, the fluorine content of the resulting polymer is preferably at least 10% by weight. If the fluorine content is too small, the specificity of fluorine containing polymer tends to hardly be obtained. Of course, a perfluoro monomer is suitably employed.

The above mentioned specific fluorine-containing monomer includes the following specific monomers: $CF_2=CFOCF_2CF=CF_2$, $CF_2=CFOCF_2CF_2CF=CF_2$, $CF_2=CFOCF_2CF=CH_2$,

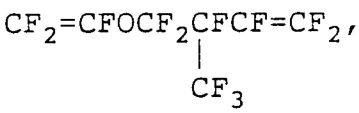 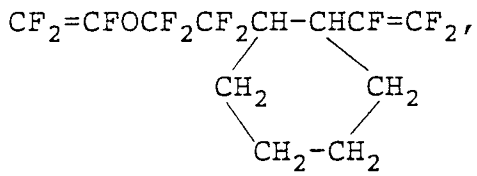

$CF_2=CFOCF_2OCF_2CF=CF_2$, $CF_2=CFOCF_2CF_2CH=CH_2$,

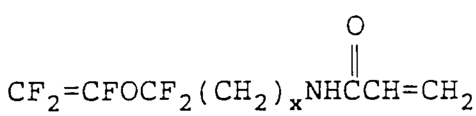

wherein x is an integer of from 0 to 3,

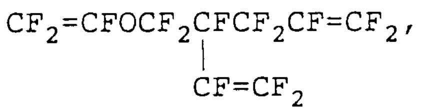 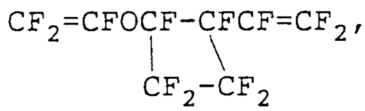

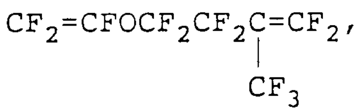 $CF_2=CFO(CF_2)_2CF=CFCF_3$,

$CF_2=CFOCF_2CF_2OCF=CFC\ell$, 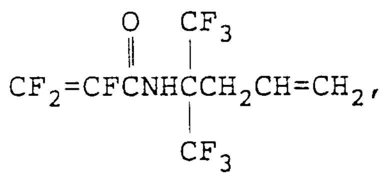

$CF_2=CFCF_2CF_2CH=CH_2$, $CF_2=CFCF_2CF_2CH=CH_2$,

$CF_2=CHOCH_2CH_2CF=CF_2$, 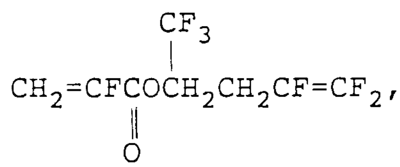

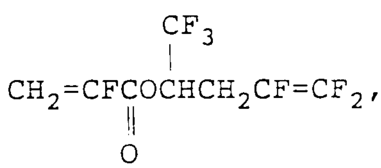 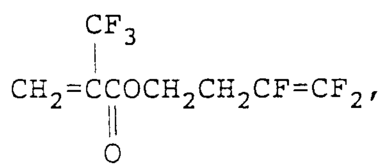

$CH_2=CHOCH_2CH_2CF_2CF=CF_2$

In the present invention, a monomer having one vinyl ether group of $CF_2=CFO$- is preferably employed from the viewpoint of the polymerization reactivity, the cyclic polymerizability and the suppression of gelation. Particularly, perfluoroallyl vinyl ether ($CF_2=CFOCF_2CF=CF_2$) and perfluorobutenyl vinyl ether ($CF_2=CFOCF_2CF_2CF=CF_2$) may be mentioned as preferred monomers.

The above mentioned monomers may be used alone or in combination as a mixture of two or more. Further, these components may be used and copolymerized with other copolymer components so long as the essential nature thereof will not thereby be impaired. If necessary, the polymer may be cross-linked by some method.

Other monomers to be copolymerized are not particularly limited so long as they are monomers having radical polymerizability, and they cover a wide range of monomers including those of a fluorine-containing type, a hydrocarbon containing type, etc. Of course, these other monomers may be radical-copolymerized alone to the above mentioned monomer capable of introducing the specific cyclic structure, or two or more appropriate types thereof may be used in combination for the above mentioned copolymerization reaction. In the present invention, it is usually preferred to select as such other monomers fluorine-containing monomers such as fluoroolefins or fluorovinyl ethers. For example, tetrafluoroethylene, perfluoromethyl vinyl ether, perfluoropropyl vinyl ether or perfluoro vinyl ether having a functional group such as a carboxylic acid group or a sulfonic acid group, may be mentioned as preferred examples. Further, vinylidene fluoride, vinyl fluoride or chlorotrifluoroethylene may also be mentioned.

As the copolymer composition, in order to obtain the characteristics of the specific fluorine-containing aliphatic cyclic structure for the purpose of the present invention, the composition of the cyclic structure is preferably at least 20 mol%, more preferably at least 40 mol%.

In the present invention, a conventional method may suitably be employed as a method for crosslinking the fluorine-containing polymer. For example, crosslinking can be conducted by copolymerizing a monomer having a crosslinking site, by adding a crosslinking agent, or by means of radiation.

Further, to improve the practical usefulness, various additives such as an antioxidant and an ultraviolet

stabilizer, may be incorporated to the fluorine-containing polymer of the present invention.

The polymer having the specific cyclic structure of the present invention is soluble in e.g. a fluorine-type solvent and can be formed into a thin uniform film on a substrate by a spin-coating method, like a conventional resist.

The solvent to be used is not limited so long as it is capable of dissolving the above polymer. However, perfluorobenzene, perfluorotributylamine, "Fluorinert" (trade name for a fluorine-type liquid manufactured by 3M Company) and trichlorotrifluoroethane may, for example, be suitably employed. Of course, it is possible to use a suitable combination of two or more solvents. In a case of a solvent mixture, a hydrocarbon, an alcohol and other organic solvents may be used in combination. The concentration of the solution is usually from 0.01 to 50% by weight, preferably from 0.1 to 20% by weight. The thin film of the fluorine-containing polymer in the present invention may be subjected to dry etching by oxygen plasma in the same manner as a polymer like a conventional resist. On the thin film of the fluorine-containing polymer, a pattern resistant to oxygen plasma, such as a metal pattern, is formed, and by using such a pattern as a mask, reactive ion etching is conducted by a parallel flat plate type etching apparatus, to form a fine pattern of the fluorine-containing polymer.

Further, the phase-shifting mask of the present invention can be produced by the process as described above. Here, as a high melting point inorganic film, a film of a metal such as molybdenum (Mo), chromium (Cr) or titanium (Ti) or of an oxide of such a metal, or an inorganic film of e.g. SiN, $SiO_2$ or carbon (C), may, for example, be mentioned.

In the present invention, the polymer having a fluorine-containing aliphatic cyclic structure has a little or no substantial crystallinity. Therefore, despite the fact that it is a fluorine resin, it has high transparency and high light transmittance. Further, since it is a fluorine-containing polymer, it has a refractive index which is lower than a usual hydrocarbon-type resin and is equal to or lower than the refractive index of glass. It can be formed into a thin film by a spin-coating method in the same manner as a polymer which is commonly used for the preparation of semiconductors, whereby a fine pattern can be formed by dry etching. Further, it is considered to be excellent also in the light resistance, moisture resistance, weather resistance and chemical resistance. Thus, it is capable of forming an excellent shifter pattern of the phase-shifting mask.

However, it should be understood that such a description is intended to help understand the present invention and by no means restrict the present invention.

Now, the present invention will be described in further detail with reference to Examples. However, it should be understood that the present invention is by no means restricted by such specific Examples.

PREPARATION EXAMPLE 1

35 g of perfluoroallyl vinyl ether, 5 g of trichlorotrifluoroethane (hereinafter referred to simply as R-113), 150 g of deionized water and 35 mg of

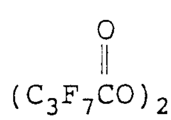

as a polymerization initiator, were introduced into a pressure resistant glass autoclave having an internal capacity of 200 mℓ. The interior of the system was flushed three times with nitrogen, and then suspension polymerization was conducted at 26 °C for 23 hours, to obtain 28 g of a polymer.

The infrared absorption spectrum of this polymer was measured, whereby no absorption was observed at about 1,790 $cm^{-1}$ and 1,840 $cm^{-1}$ attributable to a double bond as observed with the monomer. This polymer was dissolved in perfluorobenzene, and the $^{19}F$ NMR spectrum was measured to obtain a spectrum showing the following repeating structure:

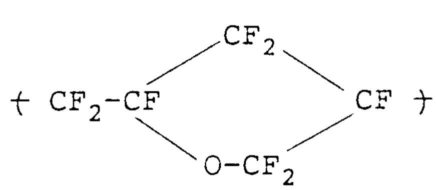

The specific viscosity [η] of this polymer was 0.530 as measured at 30 °C in "Fluorinert" FC-75 (trade

name for a liquid containing perfluoro(2-butyltetrahydrofuran) as the main component, manufactured by 3M Company, hereinafter referred to simply as FC-75). The glass transition temperature of the polymer was 69 °C, and it was a glass-like polymer which was tough and transparent at room temperature. Its 10% heat decomposition temperature was 462 °C. The refractive index was as low as 1.34. The light transmittance was as high as 95%.

PREPARATION EXAMPLE 2

20 g of 1,1,2,4,4,5,5-heptafluoro-3-oxa-1,6-heptadiene and 40 g of R-113 were introduced into a three-necked flask flushed with nitrogen, and 20 mg of

$$(C_3F_7\overset{\overset{O}{\|}}{C}O)_2$$

was added thereto as a polymerization initiator. The interior of the system was flushed with nitrogen, and the polymerisation was conducted at 18 °C for 10 hours, to obtain 10 g of a polymer. This polymer was a polymer soluble in R-113, and the specific viscosity [$\eta$] was 0.96 as measured at 30 °C in m-xylenehexafluoride. By the $^{19}F$ and $^{1}H$ NMR, it was confirmed to be a polymer having a cyclic structure on its main chain. This polymer was colorless and transparent. The refractive index was close to glass, and the light transmittance was also high.

PREPARATION EXAMPLE 3

35 g of perfluorobutenyl vinyl ether, 5 g of R-113, 150 g of deionized water and 50 mg of diisopropyl peroxydicarbonate as a polymerization initiator were introduced into a pressure resistant glass autoclave having an internal capacity of 200 mℓ. The interior of the system was flushed three times with nitrogen, and then suspension polymerization was conducted at 40 °C for 23 hours, to obtain 28 g of a polymer.

The specific viscosity [$\eta$] of this polymer was 0.50 as measured at 30 °C in "Fluorinert" FC-75. The glass transition temperature of this polymer was 108 °C, and it was a glass-like polymer which was tough and transparent at room temperature. It was confirmed to be a polymer having a cyclic structure from the $^{19}F$ NMR spectrum. Its 10% heat decomposition temperature was 465 °C. The light transmittance was as high as at least 95%.

This polymer was colorless and transparent. The refractive index to the exposure wavelength of photolithography was measured by the light transmittance, whereby the refractive index was found to be 1.362 at 436 nm, 1.365 at 365 nm and 1.384 at 248 nm. The refractive index was lower than the glass substrate, and the light transmittance was also high.

Further, with respect to the resistance to light, no change was observed against the light of 400,000 joule.

PREPARATION EXAMPLE 4

Perfluoro-2,2-dimethyl-1,3-dioxole and tetrafluoroethylene were subjected to radical copolymerization to obtain a copolymer having a glass transition point of 160 °C.

This polymer was colorless and transparent. The refractive index was 1.3, which is lower than the refractive index of the glass substrate, and the light transmittance was also high.

EXAMPLES

Now, Figure 1 shows a phase-shifting mask wherein the polymer having a fluorine-containing aliphatic cyclic structure obtained in one of Preparation Examples 1 to 4 is used as a shifter. The process for its production will be explained with reference to the drawing. Namely, Figure 3 is a cross sectional view illustrating the process for forming a shifter pattern of the polymer having the fluorine-containing aliphatic cyclic structure. Firstly, on a mask having a light shielding pattern 2 formed on a glass substrate 1 as shown in Figure 3 (1), a film 3 of the polymer having a fluorine-containing aliphatic cyclic structure, is formed by a spin-coating method, as shown in Figure 3 (2). Then, a Mo film 4 (thickness: 80 nm) and an electron beam resist PGMA film 5 (thickness: 500 nm) are sequentially formed. Then, the resist is subjected

to exposure by an electron beam exposure apparatus to form a desired resist pattern. Then, as shown in Figure 3 (4), the Mo film is subjected to etching by a reactive ion etching method employing $CF_4 + O_2$ gas while using the resist pattern as a mask, to form a Mo pattern. Then, as shown in Figure 3 (5), the film 3 of the polymer having a fluorine-containing aliphatic ring structure is subjected to etching by a reactive ion etching method employing $O_2$, while using the Mo film as a mask, to form a polymer pattern. Finally, as shown in Figure 3 (6), the Mo film on the polymer pattern is removed by means of a mixed acid. Thus, a phase-shifting mask having the polymer having a fluorine-containing aliphatic cyclic structure, as a shifter, is completed.

The pattern of this mask was transferred by means of a stepper using i-ray (wavelength: 365 nm) as a light source, whereby a pattern of 0.3 $\mu$m which could not have been dissolved by a conventional mask, was formed in each case where the polymer obtained in each of Preparation Examples 1 to 4 was employed.

The thickness of the film of the polymer containing a fluorine-containing aliphatic cyclic structure was determined to satisfy the following formula:

$$t = \lambda/(2(n-1))$$

where t is the film thickness, $\lambda$ is the wavelength of the stepper, and n is the refractive index at that wavelength.

For example, in the case of the polymer of Preparation Example 3, the film thickness was adjusted to be 500 nm, since the refractive index at a wavelength of 365 nm was 1.365.

The above formula represents the condition for shifting the phase for 180°. The present invention is not limited to such a formula, since the phase-shifting mask is available wherein the shifting degree is other than 180°.

The present invention provides an excellent effect that by using a polymer having a fluorine-containing aliphatic cyclic structure as a shifter material, it is possible to obtain a shifter pattern which has a refractive index equal to or lower than a glass substrate and which has a high transmittance of a light of exposure wavelength. Further, etching can readily be conducted by using an oxygen plasma, whereby there is a merit that an etching selectivity between the glass substrate and the light shielding film can be taken. Further, the film can be formed by a spin-coating method, whereby the process for forming the phase-shifting pattern can be simplified. Further, the one having a particularly high fluorine-content, has high heat resistance, chemical resistance, moisture resistance and stain resistance and thus can be used as a permanent shifter.

**Claims**

1. A phase-shifting mask to be used for increasing the resolving power of photolithography, which has a shifter pattern to shift the phase of light, wherein the shifter pattern is made of a polymer having a fluorine-containing aliphatic cyclic structure.

2. The phase-shifting mask according to Claim 1, wherein the polymer having a fluorine-containing aliphatic cyclic structure is a polymer having the cyclic structure in its main chain, obtained by cyclic polymerization.

3. The phase-shifting mask according to Claim 1, wherein the polymer having a fluorine-containing aliphatic cyclic structure is a polymer having the cyclic structure in its main chain, obtained by cyclic polymerization of a monomer having, in its molecule, two carbon-carbon multiple bonds differing in the polymerizability.

4. The phase-shifting mask according to Claim 3, wherein the monomer is the one wherein the straight chain portion of the linking chain connecting the two carbon-carbon multiple bonds has from 2 to 7 carbon atoms.

5. The phase-shifting mask according to Claim 1, wherein the polymer having a fluorine-containing aliphatic cyclic structure is a polymer having the cyclic structure in its main chain, obtained by cyclic polymerization of at least one monomer selected from the group consisting of a perfluoroallyl vinyl ether and a perfluorobutenyl vinyl ether.

6. The phase-shifting mask according to Claim 1, wherein the polymer having a fluorine-containing

aliphatic cyclic structure is a polymer having the cyclic structure in its main chain, obtained by radical polymerization of a cyclic monomer.

**7.** The phase-shifting mask according to Claim 1, wherein the polymer having a fluorine-containing aliphatic cyclic structure is a polymer having the cyclic structure in its main chain, obtained by radical polymerization of perfluoro-2,2-dimethyl-1,3-dioxol.

**8.** The phase-shifting mask according to Claim 1, wherein the polymer having a fluorine-containing aliphatic cyclic structure is a polymer containing at least 20 mol% of the cyclic structure.

**9.** A process for producing a phase-shifting mask, which comprises a step of forming on a mask substrate a film of a polymer having a fluorine-containing aliphatic cyclic structure, a step of forming on the polymer film a high melting point inorganic film, a step of forming on the high melting point inorganic film a resist pattern by an electron beam exposure method, a step of etching the high melting point inorganic film while using the resist pattern as a mask, a step of etching the polymer film while using the high melting point inorganic pattern as a mask, and a step of removing the high melting point inorganic film on the polymer pattern by a mixed acid. 10. The process according to Claim 9, wherein the high melting point inorganic film is a molybdenum film.

FIGURE 1

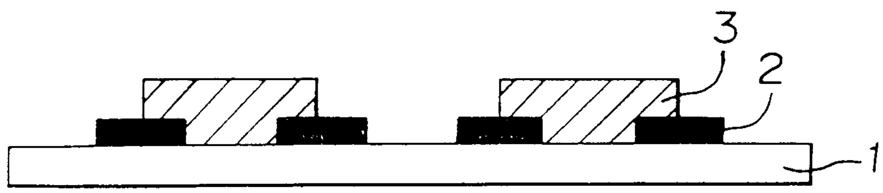


FIGURE 2

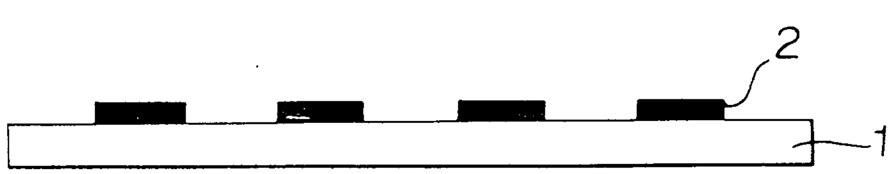

FIGURE 3

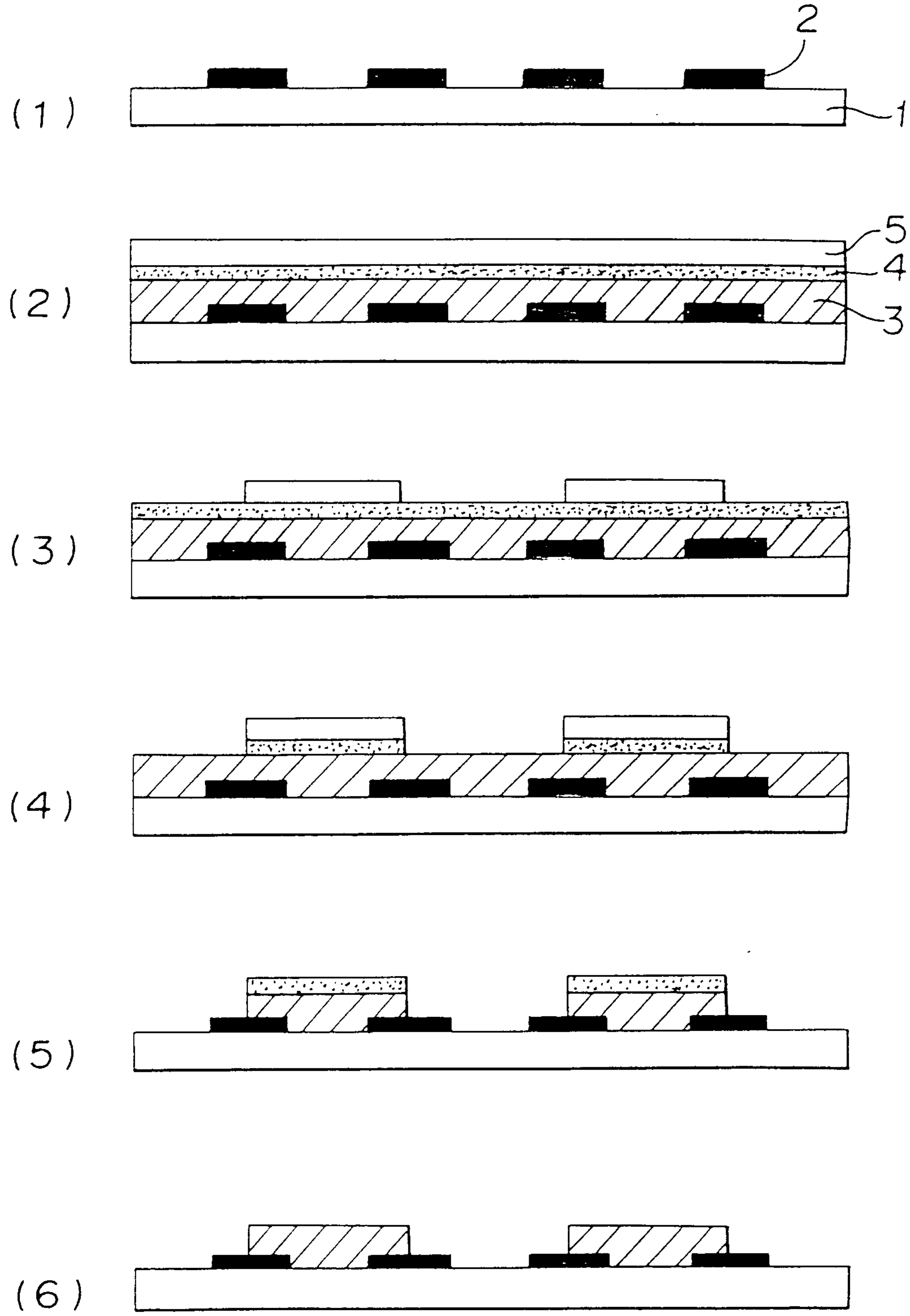

European Patent Office

# EUROPEAN SEARCH REPORT

Application Number

EP 91 12 0313

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 383 534 (KABUSHIKI KAISHA TOSHIBA)<br>* column 21, line 6 - line 31 *<br>--- | | G03F1/14 |
| P,A | PATENT ABSTRACTS OF JAPAN<br>vol. 15, no. 247 (P-1219)25 June 1991<br>& JP-A-3 078 747 ( HITACHI LTD ) 3 April 1991<br>* abstract *<br>----- | | |
| | | | TECHNICAL FIELDS SEARCHED (Int. Cl.5) |
| | | | G03F |

The present search report has been drawn up for all claims

| Place of search | Date of completion of the search | Examiner |
|---|---|---|
| THE HAGUE | 20 MARCH 1992 | BARATHE R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)